(19) Europäisches Patentamt
European Patent Office
Office européen des brevets

(11) **EP 0 610 918 B1**

(12) **EUROPÄISCHE PATENTSCHRIFT**

(45) Veröffentlichungstag und Bekanntmachung des Hinweises auf die Patenterteilung:
**06.08.1997   Patentblatt 1997/32**

(51) Int Cl.[6]: **G01S 17/10**, G01S 7/48

(21) Anmeldenummer: **94101989.5**

(22) Anmeldetag: **09.02.1994**

(54) **Vorrichtung zur Messung der Laufzeit von elektromagnetischen Wellen**

Device for measuring the time of flight of electromagnetic waves

Appareil de mesure du temps de vol d'ondes électromagnétiques

(84) Benannte Vertragsstaaten:
**CH DE DK FR LI**

(30) Priorität: **12.02.1993   DE 4304290**

(43) Veröffentlichungstag der Anmeldung:
**17.08.1994   Patentblatt 1994/33**

(73) Patentinhaber: **SICK AG**
**79183 Waldkirch (DE)**

(72) Erfinder: **Hug, Gottfried**
**D-79183 Waldkirch-Siensbach (DE)**

(74) Vertreter: **Dipl.-Phys.Dr. Manitz**
**Dipl.-Ing. Finsterwald Dipl.-Ing. Grämkow**
**Dipl.-Chem.Dr. Heyn Dipl.-Phys. Rotermund**
**Morgan B.Sc.(Phys.)**
**Robert-Koch-Strasse 1**
**80538 München (DE)**

(56) Entgegenhaltungen:
**EP-A- 0 166 106          EP-A- 0 173 087**
**DE-C- 4 002 356**

## Beschreibung

Die Erfindung betrifft eine Vorrichtung zur Messung der Laufzeit von Lichtwellen, nach dem Oberbegriff des Patentanspruches 1.

Bei einer bekannten derartigen Vorrichtung (DE-PS 34 29 062) werden die vom Impulsgenerator abgegebenen Einzelimpulse in einen dachartigen Impuls mit deutlicher Spitze umgeformt, und es erfolgt in der Impulsempfangs-Zeitpunkt-Festlegeschaltung eine Differenzierung des Impulssignals, worauf anschließend eine Nulldurchgangsdetektion des differenzierten Signals erfolgt. Durch das Differenzieren der Impulsrampen entsteht ein positiver bzw. negativer Bereich, in dem Rauschsignale des Signals erlaubt sind und für die Signalverarbeitung ohne Folgen bleiben. Dieser Bereich ist aber signalabhängig und erfordert eine analoge Signalverarbeitung im Verstärkerteil. Einfache Begrenzerverstärker sind hier nicht erlaubt, weil eine Signalbegrenzung zur Zerstörung der Flankeninformation führen würde. Da das Integral des zulässigen Rauschbereiches benötigt wird, wodurch eine energetische Verkopplung mit der Länge des Meßbereiches entsteht, wird die Energie des Sendeimpulses nur unzureichend ausgenutzt.

Das Ziel der Erfindung besteht somit darin, eine Vorrichtung der eingangs genannten Gattung zu schaffen, welche in der Lage ist, auch sehr verrauschte Signale zu verarbeiten bzw. Empfangssignale aus einem Rauschspektrum herauszufiltern. Weiter sollen an der Nahtstelle von analoger zur digitaler Signalverarbeitung die Informationsverluste so klein wie möglich gehalten werden, allerdings ohne dabei das nachgeschaltete digitale System mit Information zu überfrachten, was sowohl die Auslegung der Schnittstelle als auch das nachgeschaltete Verarbeitungssystem sehr verteuern würde. Weiter soll die Vorrichtung so gestaltet seiln, daß sie in eine digitale Einchiplösung integriert werden kann.

Zur Lösung dieser Aufgabe sind die Merkmale des kennzeichnenden Teils des Patentanspruchs 1 vorgesehen.

Erfindungsgemäß wird also nicht mehr ein einzelner Impuls, sondern vielmehr eine kurze Folge von zeitlich konsistenten Impulsen erzeugt, deren Amplitudenhöhe und Pausenzwischenräume eine konstante Größe besitzen. Ein anschließender finaler Impuls ist dadurch gekennzeichnet, daß er zur vorangehenden Impulsfolge einen Phasenversatz von 180° aufweist. Wird nun durch Einfügen eines Resonanzkreises mit vorbestimmter Güte und Frequenz der Signalpfad ergänzt, so wird die Signalenergie über der Impulsfolge akkumuliert und schließlich durch den finalen Impuls schnell dezimiert. Man erhält als Einhüllende einen Signalverlauf, dessen Einschwingphase eine Exponentialfunktion beschreibt und dann abrupt abbricht. Über die Signalauswertung hat dies zur Folge, daß nun ein Nulldurchgangsdetektor, der dem Schwingkreis nachgeschaltet sein sollte, durch die Akkumulation der Signalenergie am Ende der Impulsfolge ein Maximum an statistischer Präzision für eine zeitliche Fixierung des Empfangsereignisses erreicht hat. Dieses Maximum an statistischer Sicherheit, der wahrscheinlichste Ereigniszeitraum, wird nun durch den finalen Impuls in der Hüllkurve mit einem Dynamiksprung markiert.

Die Einführung einer Refreshzeit ist wegen der zeitlichen Länge der erfindungsgemäßen Impulsfolgen dann wichtig, wenn die Meßstrecke bzw. Referenzstrekke so kurz ist, daß ohne die Einfügung dieser Verzögerungszeit ein weiteres Triggersignal schon ausgelöst werden würde, bevor der letzte Impuls der Impulsfolge ausgesandt ist.

Vorteilhafte Weiterbildungen der Erfindung sind durch die Ansprüche 2-12 gekennzeichnet.

Nach Anspruch 2 bewirkt der Zusammenbruch der Hüllkurve durch die Nulldurchgangsdetektion eine scharfe Bestimmung des Empfangszeitpunktes. Der Hüllkurvendetektor dient dabei der Markierung desjenigen Impulses, welcher auch bei verrauschten Signalen die höchste Bestimmungsschärfe zuläßt. Nach dem Zusammenbruch der Hüllkurve erfolgt also kein Rücksetzen der durch den vorangegangenen Nulldurchgang ausgelösten Zeittriggerung mehr, wodurch dieser Nulldurchgang zeitbestimmend wird.

Der Hüllkurvendetektor setzt nach Anspruch 3 und 11 mit jedem Impuls, der den $1/\sqrt{2}$-fachen Wert der vorangegangenen Einhüllenden überschreitet, eine Zeitschaltung in den Ausgangszustand zurück. Dadurch wird der letzte Folgeimpuls vor dem finalen Phasensprung zum triggerauslösenden Empfangsereignis. Dieses Ereignis fällt mit dem Präzisionsmaximum im Ereignisraum zusammen.

Aufgrund der erfindungsgemäßen Ausbildung ist es möglich, die besonders wichtige Einchiplösung gemäß Anspruch 8 durchzuführen. Diese Ausführungsform gewährleistet also nicht nur eine exakte zeitliche Bestimmung des Empfangsereignisses, sondern auch eine kostengünstige Herstellung der erfindungsgemäßen Vorrichtung.

Die Erfindung wird im folgenden beispielsweise anhand der Zeichnung beschrieben; in dieser zeigt:

Fig. 1    ein Blockschaltbild einer erfindungsgemäßen Vorrichtung zur Laufzeitmessung,

Fig. 2    die vom Impulsgenerator nach Fig. 1 erzeugte Impulsfolge nach dem Empfang am Eingang des Resonators 35,

Fig. 3    die im Resonator 35 nach Fig. 1 entstehende Resonatorschwingung,

Fig. 4    das Ausgangssignal des Nulldurchgangsdetektors 36,

Fig. 5    das Ausgangssignal des Hüllkurvendetektors 37,

Fig. 6    das Ausgangssignal des Pretriggers 38,

Fig. 7    das Ausgangssignal des Refresh-Zeitgliedes 39 und

Fig. 8    das Triggersignal am Triggereingang 18 des Impulsgenerators 11,

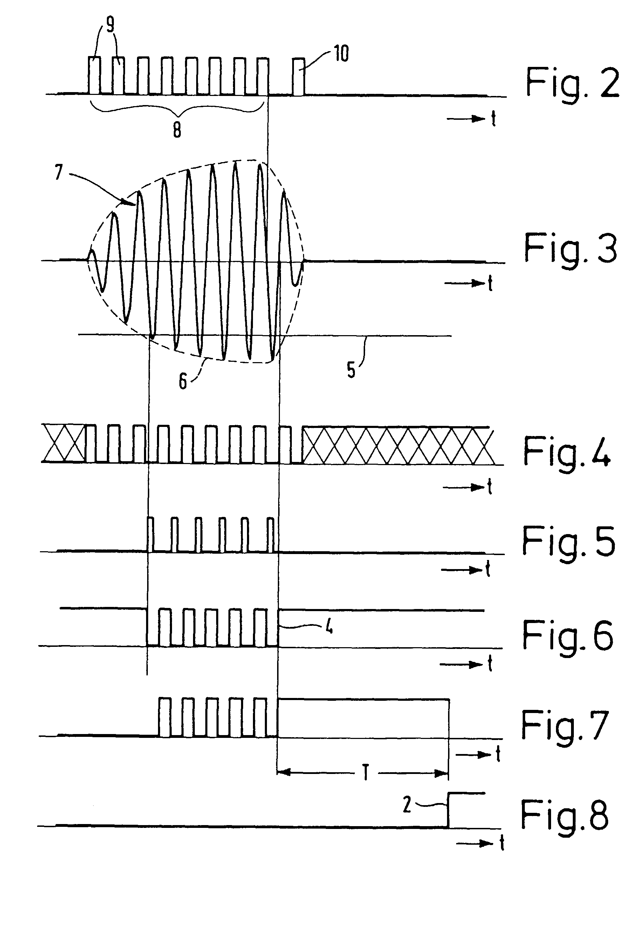

wobei in allen Fig. 2 bis 8 die Abszisse die gleiche Zeitachse t ist.

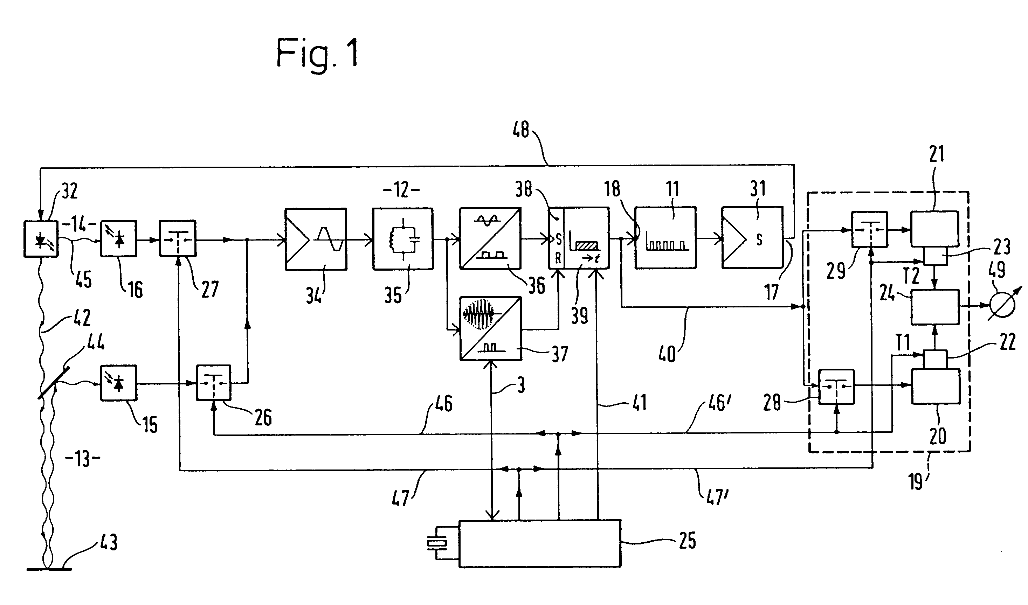

Nach Fig. 1 ist eine zentrale Zeitsteuerschaltung 25 über eine erste Steuerleitung 41 an ein Refresh-Zeitglied 39 angeschlossen, dessen Ausgang am Triggereingang 18 eines generators 11 anliegt, der bei Eintreffen eines Triggersignals eine kurze Folge von Impulsen 9, 10 aussendet, wie sie in Fig. 2 wiedergegeben sind. Die Folge von Impulsen besteht aus einer Impulsgruppe 8 von acht gleichbeabstandeten, gleich langen und gleich hohen Rechteckimpulsen 9, denen sich in einem um 180° vergrößerten Abstand ein Finalimpuls 10 anschließt.

Durch ein Startsignal in Form eines Einzelimpulses von der Zeitsteuerschaltung 25 wird am Triggereingang 18 des Impulsgenerators 11 die Aussendung einer kurzen Folge von Impulsen 9, 10 gemäß Fig. 2 ausgelöst. In einem anschließenden Modulator 31 werden die erzeugten Impulse in entsprechende Lichtimpulse umgewandelt. Der Ausgang des Modulators 31 ist über eine Leitung 48 mit einem Lichtsender 32 verbunden, der z. B. durch eine Halbleiter-Sendediode gebildet ist.

Die vom Sender 32 ausgehende Lichtwelle 42 wird teilweise zu einer Meßstrecke 13 geschickt, an deren Ende z.B. ein reflektierendes Objekt 43 angeordnet ist. Am Beginn der Meßstrecke 13 befindet sich ein Strahlenteiler 44, durch den das Sendelicht hindurchgeht und von dem das reflektierte Licht zu einem als PIN-Diode ausgebildeten Meßempfänger 15 umgelenkt wird.

Ein weiterer Teil 45 des Sendelichts wird über eine möglichst kurz ausgebildete Referenzstrecke 14 zu einem als PIN-Diode ausgebildeten Referenzempfänger 16 geleitet.

Nach Möglichkeit sollte der Abstand zwischen dem Sender 32 und dem Referenzempfänger 16 genauso groß wie zwischen dem Sender 32 und dem Strahlenteiler 44 sein. Sofern dies nicht möglich ist, können unterschiedliche Grundabstände später bei der rechnerischen Auswertung berücksichtigt werden.

An den Meß- bzw. Referenzempfänger 15 bzw. 16 schließen sich elektronische Schalter 26 bzw. 27 an, die über weitere Steuerleitungen 46, 47 von der Zeitsteuerschaltung 25 angesteuert werden.

Die Ausgänge der Schalter 26, 27 sind an den Eingang eines Amplitudenbegrenzers 34 angelegt, dem ein auf die Frequenz der Impulsgruppe 8 abgestimmter Resonator 35 folgt. In dem Amplitudenbegrenzer 34 kann auch ein Empfängervorverstärker vorgesehen sein, der die Verstärkung des Eingangssignals übernimmt, um den Störabstand für die Signalübergabe an die eigentliche Begrenzerstufe zu verbessern.

Der Amplitudenbegrenzer 34 weist ein totzeitfreies, signalbegrenzendes Verhalten auf. Er sorgt für eine gute Anpassung der nachfolgenden Schaltungsstufen an die geforderte Signaleingangsdynamik. Durch eine hohe Verstärkung, die zu den Begrenzungspegeln hin stark abnimmt, werden bei den hier vorliegenden Signalanforderungen die Eigenschaften eines sehr viel aufwendigeren Regelverstärkers substituiert.

Die prinzipbedingten Flankenverzerrungen werden wegen der Symmetrieerfüllung durch den nachgeschalteten Resonator 35 entzerrt, wodurch eine kostengünstige Integration des Begrenzers 34 ermöglicht wird. Er läßt sich durch einfache gegengekoppelte Inverter realisieren, die wegen der hohen Arbeitsfrequenzen mit integrationsfähigen Entkoppelkondensatoren ausgestattet sein können.

Der Resonator 35, der als einziges Bauelement der Kette 34 bis 31 nicht in ein und demselben Halbleiterbauelement-Chip integriert ist, besteht aus einem einfachen LC-Glied, welches dem Amplitudenbegrenzer 34 nachgeschaltet ist. Der Resonator 35 sorgt für die beschriebene Begrenzerentzerrung und eine wirksame Signalfilterung.

Das am Ausgang des Resonators 35 anliegende Schwingungssignal ist in Fig. 3 veranschaulicht. Durch die Abstimmung des Resonators 35 auf die Frequenz der Impulsgruppe 8 aus Impulsen 9 wird die Signalenergie über die Impulsfolge akkumuliert. Durch den um zusätzliche 180° versetzten finalen Impuls 10 wird jedoch die Resonatorschwingung sehr schnell zum Erliegen gebracht.

An den Resonator 35 sind parallel ein Nulldurchgangsdetektor 36 und ein Hüllkurvendetektor 37 angeschlossen.

Der Nulldurchgangsdetektor 36 erfüllt die Symmetriebedingung für eine statistische Bewertung eines Zeitjitters. Er ist so verschaltet, daß er vorzeichenabhängig mit jedem entsprechenden Nulldurchgang einen anschließend vorgesehenen Pretrigger 38 triggert.

Der Ausgang des Hüllkurvendetektors 37 ist an den Rücksetzeingang eingang R des Pretriggers 38 angeschlossen, an dessen Setzeingang S der Ausgang des Nulldurchgangsdetektors 36 anliegt. Der Hüllkurvendetektor 37 liefert außerdem über eine bidirektionale Verbindungsleitung 3 Informationen über die Qualität der Detektion (Anzahl und Verteilung der Impulse) an die Zeitsteuerschaltung 25, woraus diese über einen Soll-Ist-Vergleich (digitaler Zählvorgang) die Ansprechschwelle nachregelt. Dadurch erfolgt auf einfache Weise eine automatische Anpassung an den Resonatorpegel und dessen Eingangssignal.

Dem Pretrigger 38 folgt ein Refresh-Zeitglied 39, welches für die nötige Erholzeit aller transienten Vorgänge sorgt. Eine digitale Realisierung durch einen asynchronen taktunabhängigen Start-Stopp-Generator (Ringoszillator) mit kurzer Zählerkette erfüllt diese Anforderung.

Der Ausgang des Refresh-Zeitgliedes 39 ist an den Triggereingang 18 des Impulsgenerators 11 angelegt. Auf diese Weise wird eine Rückkopplungsschleife 12 geschlossen.

Alle Impulse 9 sind mit Ausnahme des 180°-phasenversetzten Impulses 10 vorzugsweise in ihrer Basisbreite und der dazwischenliegenden Pausenzeit symmetrisch aufgebaut. Dadurch wird der nutzbare Grundwellenanteil erhöht und der Oberwellenanteil beschränkt. Damit wird die Impulsbreite also durch die Resonatorfrequenz vorgegeben, für welche Werte von 10 MHz bis 1 GHz in Frage kommen, wobei aus wirtschaftlichen Gründen bei nicht wesentlich über 100 MHz gearbeitet werden sollte. Die zugeordneten Impulszeiten können also mit 0,5 ns bis 50 ns betragen.

Die Wirkungsweise der beschriebenen Schaltung wird im folgenden anhand der Diagramme der Fig. 2 bis 8 beschrieben.

Die Impulsfolge nach Fig. 2 hat im Resonator 35 eine Schwingung 7 gemäß Fig. 3 zur Folge, die gleichzeitig eine Hüllkurve 6 definiert. Im Nulldurchgangsdetektor 36 wird bei jedem ansteigenden Nulldurchgang der Schwingung 7 ein Impuls gesetzt und bei jedem abfallenden Nulldurchgang rückgesetzt, so daß eine Impulsfolge entsteht, wie sie in Fig. 4 wiedergegeben ist.

In der Zeitsteuerschaltung 25 wird jeweils die Detektionsqualität des vorangehenden Zyklus gespeichert. Gespeichert wird also nur das Ergebnis der Detektion dieser Hüllkurve 6, nicht die Hüllkurve selbst. Da diese Auswertung durch Abzählen der Schaltimpulse des Hüllkurvendetektors und durch Vergleich mit einer Sollvorgabe von n Impulsen (in Fig.3 sind es sechs Impulse) erfolgt, wird bei einer Abweichung der Ist-Impulszeit eine Nachführung der Detektionsschwelle 5 erreicht und dadurch eine automatische Pegelanpassung bewirkt.

Werden z.B. statt der sechs Impulse von Fig. 3 nur fünf Impulse gezählt, muß die Schwelle 5 nach unten korrigiert werden. Bei sieben Impulsen läge sie zu tief und müßte nach oben korrigiert werden. Dies übernimmt ein Dreipunktregler mit drei Ausgangszuständen. Die Schwelle 5 ist richtig eingepegelt, wenn gemäß Fig. 3 sechs Impulse gezählt werden. Hier ist die Detektionsqualität optimal, es erfolgt keine Korrektur. Bei abweichender Impulszahl ist die Qualität nicht zufriedenstellend, und es erfolgt eine Korrektur. Dabei bestimmt die Detektionsqualität des vorangehenden Zyklus die Schwellenvorgabe für den nächsten Zyklus. Die Speicherung des Ergebnisses der Detektion, d.h. der Detektionsqualität erfolgt digital durch Festhalten der Abweichung, und die Ausgabe erfolgt zeitproportional durch positive bzw. negative Stromimpulse, welche - in einen analogen Kondensator eingespeist - den Schwellenpegel darstellen. Durch diese digitale Speicherung und die nachfolgende zeitproportionale Ausgabe von n Impulsen wird diese Funktion der Zeitsteuerschaltung 25 zugeordnet.

Die in Fig.3 gezeigte Schwelle 5 entspricht dem $1/\sqrt{2}$-fachen des Maximums der vorangehenden Hüllkurve 6. Der Hüllkurvendetektor 37 ist nun so ausgelegt, daß er immer dann, wenn und solange wie die Resonatorschwingung nach Fig.3 die Schwelle 5 unterschreitet, ein Impuls an den Reset-Eingang des Pretriggers 38 abgegeben wird, so daß insgesamt am Ausgang des Hüllkurvendetektors 37 eine Impulsfolge gemäß Fig.5 entsteht.

Während die ansteigenden Flanken der vom Nulldurchgangsdetektor 36 an den Setzeingang S des Pretriggers 38 abgegebenen Impulse (Fig. 4) den Pretrigger 38 setzen, wird er durch die ansteigenden Flanken der Hüllkurvenimpulse nach Fig.5 rückgesetzt. Demnach entsteht am Ausgang des Pretriggers 38 eine Impulsfolge, wie sie in Fig. 6 wiedergegeben ist. Man erkennt, daß die ansteigende Flanke 4 des letzten Setzvorganges des Pretriggers 38 als Maß für das Ereignis, d.h. das Eintreffen der Impulsfolge verwendet werden kann, weil diese Zeit sehr exakt bestimmt und weitgehend frei von Rauscheinflüssen ist.

Im anschließenden Refresh-Zeitglied 39 wird gemäß Fig.7 eine konstante Verzögerungszeit T eingeführt, nach welcher das bis dahin konstante Signal auf Null abfällt und gemäß Fig. 8 eine Triggerimpulsflanke 2 erzeugt wird, die an den Triggereingang 18 des Impulsgenerators 11 die nächste Folge von Impulsen 9, 10 gemäß Fig. 2 auslöst.

Die Verzögerungszeit T wird so gewählt, daß die nötige Erholzeit für alle transienten Vorgänge vorhanden ist. Durch die Einführung der Verzögerungszeit T wird auch die nicht vernachlässigbare zeitliche Länge der Impulsfolge 9, 10 berücksichtigt. Wie sich durch einen Vergleich der Diagramme nach den Fig. 2 und 6 ergibt, kann die das Ereignis feststellende Flanke 4 des Impulszuges nach Fig. 6 bereits auftreten, bevor der Finalimpuls 10 der Impulsfolge 9, 10 ausgesandt worden ist. Um auch bei kurzen Meß- und Referenzstrecken 13 bzw. 14 sicher zu sein, daß eine neue Impulsfolge im Impulsgenerator 11 erst nach vollständigem Abklingen des vorangehenden Sendevorganges im Impulsgenerator 11 ausgelöst wird, wird der exakt das Ereignis anzeigenden Flanke 4 nach Fig. 6, die bei kurzer Strecke vor Aussendung des Finalimpulses 10 erscheinen kann, eine entsprechend gewählte konstante Verzögerungszeit T (Fig. 7) nachgeschaltet, an deren Ende die Triggerimpulsflanke 2 gebildet wird. Die Zeit T kann je nach dem anstehenden Meßproblem fest voreinstellbar sein. Werden z.B. nur längere Meßstrecken 13 verwendet und ist auch die Referenzstrecke 14 ausreichend lang, kann die Verzögerungszeit T auf einen relativ kurzen Wert eingestellt werden oder sogar ganz entfallen. Bei kurzen Meß- und Referenzstrecken muß T dagegen entsprechend länger gewählt werden. Eine digitale Realisierung durch einen asynchronen uhrunabhängigen Start-Stopp-Generator (Ringoszillator) mit kurzer Zählerkette erfüllt diese Anforderung.

Vom Ausgang des Refresh-Zeitgliedes 39 führt eine Leitung 40 zu einer Rechen-Zählstufe 19, welche zwei elektronische Schalter 28 bzw. 29 enthält, die über Steuerleitungen 46' bzw. 47' von der Zeitsteuerschaltung 25 in der gleichen Weise wie die elektronischen Schalter 26 bzw. 27 angesteuert werden.

An die Ausgänge der Schalter 28, 29 sind ein Meßzähler 20 bzw. ein Referenzzähler 21 angelegt. Die aufaddierten Zählerstände werden an Dividierstufen 22, 23 angelegt, denen als weiteres Eingangssignal ein für den Meßzeitraum T1 bzw. den Referenzzeitraum T2 repräsentatives Eingangssignal zugeführt wird. Die Ausgänge der Dividierstufen 22, 23 liegen an einer Differenzbildungsstufe 24 an, an deren Ausgang ein Anzeigegerät 49 angeschlossen ist, welches die Laufzeit der Impulse über die Meßstrecke 13 zur Anzeige bringt.

Bis auf die erhebliche Eingrenzung der Rauschbandbreite und damit eine weitere Steigerung der Detektivität ist die Arbeitsweise der anhand von Fig. 1 beschriebenen Vorrichtung die gleiche wie die nach der Patentschrift 34 29 062, und zwar insbesondere, was die dort beschriebene Auswertung der Laufzeitmessungen anbetrifft. Die erfindungsgemäß ausgebildeten Schaltstufen 34 bis 39 und 11, 31 und die erweiterten Funktionen der Schaltschwellennachführung in der Schaltung 25 können also mit den übrigen, bereits aus der DE-PS 34 29 062 bekannten Schaltungsteilen, insbesondere den Schaltungsteilen 15, 16, 19, 26, 27, 32 und 49 vorteilhaft kombiniert werden.

Die zeitlich synchrone Ankopplung des Impulsgenerators 11 an den Refreshtimer 39, welcher als Ringoszillator ausgeführt sein kann, erlaubt ein rein digitales Design dieser Teilkomponente. Dabei ist ein zustandsgesteuerter Logikmodul ebenso geeignet wie ein Code-ROM.

Der Modulator 31 besteht aus einer Ausgangsstufe mit erhöhter Stromtragfähigkeit. Wegen der rein digitalen, also geschalteten Modulation kann hier auf eine Standardlösung zurückgegriffen werden. Durch eine Einchiplösung sind Verkopplungen über eine getrennte Versorgungszuführung mit dem empfindlichen Eingangssignal vermeidbar.

Aufgrund der erfindungsgemäßen Ausbildung ist es möglich, Signale bis hinab zur Rauschäquivalenz zu detektieren. Dabei wird das überlagerte Rauschsignal einer echten statistischen Bewertung zugänglich gemacht. Die Rauschbandbreite wird zusätzlich durch den Resonator 35 stark reduziert. Beides führt zu einer signifikanten Steigerung der Systemdetektivität. Gleichzeitig sorgt derselbe Resonator 35 aber auch für eine wirksame Laufzeitentzerrung eines nun erlaubten integrationsfähigen Begrenzers im Signalverstärkertrakt. Die Nulldurchgangs-Detektion ermöglicht darüber hinaus den Verzicht auf übliche Komparatoren. Diese können auch hier durch integrationsfähige Begrenzer substituiert werden. Dadurch wird nicht nur die störende Laufzeitdispersion reduziert, es werden zudem Kosten, Raumbedarf und Verlustleistung eingespart. Ermöglicht wird dies durch die vorteilhafte Kombination der Nulldurchgangs- und Hüllkurvendetektion. Eine Schlüsselfunktion übernimmt ferner der Resonator 35 in Verbindung mit der besonderen Ausgestaltung des Sendesignals, welches auch eine unkomplizierte digitale Modulation des Senders erlaubt. Diese digitale, übersteuerungsfeste Ausgestaltung ermöglicht erst den preiswerten integrationsfähigen Begrenzer 34 im Signaleingangsteil. Der hohe Nutzungsgrad der Sendeenergie, der durch die gute Korrelation von Sende- und Empfangsspektrum erreicht wird, steigert die Effizienz.

Bei Verwendung von Laserdioden als Sendeelemente tritt im Zusammenhang mit einer Impulsaussteuerung eine sog. Modenkonkurrenz auf. Diese erzeugt ihrerseits eine Laufzeitfluktuation von einigen 100 ps. Dieser für die Erzielung einer hohen Reproduziergenauigkeit sehr störende Effekt wird hier durch Ausbildung eines integralen Phasenverlaufes mittels der senderseitigen Burstausgestaltung wirksam reduziert. Man erhält eine mit dem CW-Verfahren vergleichbare Phasenruhe.

Ein wichtiger Vorteil der Erfindung besteht in der sehr guten Verträglichkeit mit digitalen Integrationstechniken, wodurch eine hohe Integrationstiefe mit niedrigen Systemkosten ermöglicht wird.

Die Triggerimpulse beinhalten vom Sendezeitpunkt bis zur Triggerauslösung Laufzeitanteile der internen Baugruppen, der externen medieninhärenten Durchlaufzeit und zudem rauschbedingte Zeitfluktuationen. Die interne Gruppenlaufzeit kann in die stationäre exemplarabhängige Bauteiledurchlaufzeit und weiter in einen temperatur- und alterungsabhängigen Laufzeitanteil aufgespalten werden. Insbesondere der letztgenannte Anteil macht die Kompensation oder Korrektur durch eine Referenzmessung mit kurzgeschlossener Meßstrecke nötig. Dem rauschbedingten Fluktuationsanteil kann bei großer Zahl der Einzelproben mit den Methoden der Statistik begegnet werden. Durch diese Maßnahmen ist eine erhebliche Qualitätsverbesserung der Ergebnisse möglich. Diese werden in bezug auf die Meßstrecke dadurch erst aussagekräftig. Ein Problem, das dabei zunächst überwunden werden muß, ist die extrem hohe Zeitauflösung von wenigen Picosekunden oder darunter. Hierzu werden die Grundlagen verwendet, die in der Patentschrift 34 29 062 beschrieben sind.

Die erwünschte hohe Zeitauflösung wird durch Transformation des Zeitbereiches um mehrere Größenordnungen erreicht. Dabei wird eine geschlossene Zeitkette gebildet. Ein durch das Sendesignal mit der Durchlaufzeit aller erwähnten Zeitfraktionen beladenes Empfangssignal triggert eine Zeitschaltung, welche für eine Erholzeit aller Transienten sorgt und ihrerseits erneut die Aussendung der weiter oben beschriebenen Impulsabfolge veranlaßt. Durch die sehr große Zahl der Zeitkettenglieder - auch Schlaufendurchläufe genannt -, welche während eines Auswertezeitraums einige tausend betragen kann, ist es möglich, durch einfaches Abzählen der Schlaufendurchläufe innerhalb einer quarzstabilen Zeitperiode oder durch Auszählen eines Zeitmaßstabes innerhalb einer vorgegebenen Zahl n Schlaufendurchläufe eine Quantisierung vorzunehmen. Die systeminhärente Gruppenlaufzeit ist von der Gessamtmeßzeit zu subtrahieren.

Die dargestellte und beschriebene Rechen-Zählstufe 19 kann wie folgt noch vereinfacht werden:
Nach der Laufzeittransformation mit dem erfindungsgemäßen Verfahren wird bei einer konstanten Zahl von n Schlaufendurchgängen der Zeitbedarf der Referenzmessung $t_r$ vom Zeitbedarf der Gesamtmessung $t_g$, welche zusätzlich die Durchlaufzeit $t_m$ der Meßstrecke beinhaltet, subtrahiert. Es ergibt sich also folgender Zusammenhang:

$$t_m = t_g - t_r \,.$$

Dies geschieht im einfachsten Fall in einer Anordnung mit Vor-Rückwärts-Zähler, der die Zähler 20, 21 ersetzt. Auf die beiden Dividierstufen 22, 23 kann dabei verzichtet werden. Die Umschalter 28, 29 werden durch eine Umschaltsteuerung ersetzt, welche die jeweilige Zählrichtung bestimmt. Dabei wird zunächst ansteigend der Zeitmaßstab über der Gesamtmeßzeit eingetaktet und danach abfallend mit demselben Zeitmaßstab die Referenzmeßzeit ausgetaktet. Im Zähler steht nun das mit dem Zeittransformationsfaktor multiplizierte Ergebnis der Durchlaufzeit aus der Meß'strecke. Dieses Ergebnis ist der Meßstrecke direkt proportional. Es ist frei von Gruppenlaufzeit und deren Driftanteilen, und es ist unter der Wurzel des Transformationsfaktors statistisch aufgewertet, was z.B. bei einem Faktor 10 K ein um den Faktor 100 stabileres Resultat ermöglicht. Eine Eichung in mm, cm oder Zoll ist durch Wahl der Quarzzeitbasis und durch Vorgabe der Schlaufendurchläufe n direkt möglich.

## Patentansprüche

1. Vorrichtung zur Messung der Laufzeit von Lichtwellen, über eine Meßstrecke (13) vorbestimmter Länge mit einem durch einen elektrischen Impulsgenerator (11) angesteuerten Sender (32), welcher die elektrische Welle in Form von Wellenimpulsen über die Meßstrecke (13) schickt, und mit einem am Ende der Meßstrecke (13) vorgesehenen Meßempfänger (15), der die Wellenimpulse aufnimmt und in einen elektrischen Empfangsimpuls umwandelt, wobei der durch eine Impulsflanke triggerbare Impulsgenerator (11) und ein von ihm beaufschlagter Lichtmodulator (31) in einer zwischen dem Ausgang (17), des Lichtmodulators (31) und dem Triggereingang (18) verlaufenden Rückkopplungsschleife (12) angeordnet sind, welche vor dem Impulsgenerator (11) eine Impulsempfangs-Zeitpunkt-Festlegeschaltung (34, 35, 36, 37, 38, 39) aufweist und in welche im Gegentakt entweder die Meßstrecke (13) oder eine am Ende einen Referenzempfänger (16) aufweisende Referenzstrecke (14) während eines Meßzeitraumes (T1) bzw. eines Referenzzeitraumes (T2), die beide groß gegenüber der Impulswiederholzeit sind, einbeziehbar ist und wobei eine Rechen-Zählstufe (19) die Umläufe der Wellenimpulse in der Rückkopplungsschleife (12) zählt sowie aus der Länge des Meß- bzw. Referenzzeitraumes und der Zahl der während dessen abgegebenen Impulse die Laufzeit errechnet, dadurch gekennzeichnet, daß der Impulsgenerator (11) bei jeder Triggerung eine kurze Folge von gleich langen und gleiche Amplitude aufweisenden Impulsen (9, 10) abgibt, wobei der Abstand zwischen zwei aufeinanderfolgenden ausgesendeten Impulsen bis auf den Abstand des letzten Impulses (10) vom vorletzten Impuls gleich ist und der letzte Impuls (10) gegenüber dem vorletzten einen zusätzlichen Phasenversatz um 180° aufweist, daß die Impulsempfangs-Zeitpunkt-Festlegeschaltung einen auf die Frequenz der vor dem um 180° zusätzlich phasenversetzten Impuls (10) vorliegenden Impulsgruppe (8) aus aufeinanderfolgenden Impulsen (9) mit gleichem Abstand voneinander abgestimmten Resonator (35) und anschließend an den Resonator (35) eine Detektorschaltung (36, 37, 38, 39) umfaßt, welche aufgrund des plötzlichen Zusammenbrechens der durch die Impulsgruppe (8) angeregten Resonatorschwingung (7) die Zeit des unmittelbar vorangehenden Nulldurchganges als Empfangszeitpunkt der kurzen Folge von Impulsen (9, 10) definiert, von dem aus nach einer vorbestimmten Refresh-Zeit die Auslösung der nächsten kurzen Folge von Impulsen (9,10) erfolgt.

2. Vorrichtung nach Anspruch 1, dadurch gekennzeichnet, daß die Detektorschaltung einen Nulldurchgangsdetektor (36) und einen diesem parallelgeschalteten Hüllkurvendetektor (37) aufweist, an deren Eingänge der Ausgang des Resonators (35) angelegt ist und deren Ausgänge an den Setz (S)- bzw. Rücksetz (R)-Eingang eines Pretriggers (38) angelegt sind, derart, daß nach dem Zusammenbrechen der durch die Impulsgruppe (8) angeregten Resonatorschwingung (7) nur noch der unmittelbar vorangehende Nulldurchgang der Resonatorschwingung den Pretrigger (38) setzt, das nächste Maximum der Resonatorschwingung jedoch den Pretrigger (38) nicht mehr rücksetzen kann.

3. Vorrichtung nach Anspruch 2, dadurch gekennzeichnet, daß der Hüllkurvendetektor (37) ein Rücksetzungssignal nur dann abgibt, wenn die Resonatorschwingung einen vorbestimmten Bruchteil des Maximums der Hüllkurve (6) der einem Zyklus vorausgehenden Resonatorschwingung (7) überschreitet und die dafür erforderliche Schwellenbildung mittels Auszählung der Hüllkurvenimpulse erfolgt.

4. Vorrichtung nach einem der vorhergehenden Ansprüche, dadurch gekennzeichnet,

daß im Anschluß an den Pretrigger (38) ein Refresh-Zeitglied (39) vorgesehen ist, welches die Abgabe eines Zähl-Triggerimpulses an den Impulsgenerator (11) und die Rechen-Zählstufe (19) um eine feste Regenerationszeit verzögert.

5. Vorrichtung nach einem der vorhergehenden Ansprüche,
dadurch gekennzeichnet,
daß die feste Refresh- bzw. Regenerationszeit 2 bis 200 ns, vorzugsweise 20 bis 100 ns und insbesondere zwei Schwingungsperioden der Resonanzfrequenz beträgt.

6. Vorrichtung nach einem der vorhergehenden Ansprüche,
dadurch gekennzeichnet,
daß vor dem letzten, um 180° zusätzlich phasenversetzten Impuls (10) 3 bis 10, vorzugsweise 5 bis 9 und insbesondere 8 gleich beabstandete Impulse (9) vorgesehen sind.

7. Vorrichtung nach einem der vorhergehenden Ansprüche,
dadurch gekennzeichnet,
daß vor dem Resonator (35) ein Amplitudenbegrenzer (34) angeordnet ist.

8. Vorrichtung nach einem der vorhergehenden Ansprüche,
dadurch gekennzeichnet,
daß der Begrenzer (34), der Nulldurchgangsdetektor (36), der Hüllkurvendetektor (37), der Pretrigger (38), das Refresh-Zeitglied (39) und der Impulsgenerator (11) an einem einzigen Halbleiterbauelement-Chip ausgebildet sind.

9. Vorrichtung nach einem der vorhergehenden Ansprüche,
dadurch gekennzeichnet,
daß die Rechenzählstufe (19) einen Vor-Rückwärtszähler umfaßt, bei dem zunächst in einer Zählrichtung die Meßzeit eingetaktet und dann in entgegengesetzter Zählrichtung die Referenzzeit ausgetaktet wird.

10. Vorrichtung nach einem der vorhergehenden Ansprüche,
dadurch gekennzeichnet,
daß die Refresh- bzw. Regenerationszeit (T) so lang gewählt ist, daß vor dem Erscheinen der Triggerimpulsflanke (2) der zugeordnete Sendevorgang im Impulsgenerator (11) vollständig abgeklungen ist.

11. Vorrichtung nach Anspruch 3,
dadurch gekennzeichnet,
daß der vorbestimmte Bruchteil das $1/\sqrt{2}$-fache des

Maximums der Hüllkurve (6) der einem Zyklus vorausgehenden Resonatorschwingung (7) überschreitet.

12. Vorrichtung nach Anspruch 3,
dadurch gekennzeichnet,
daß die Schwellenbildung durch eine digitale Dreipunktregelung mittels Auszählung der Hüllkurvenimpulse erfolgt.

**Claims**

1. Apparatus for measuring the transit time of light waves over a measurement path (13) of predetermined length comprising a transmitter (32) controlled by an electrical pulse generator (11) which transmits the electrical wave in the form of wave pulses over the measurement path (13) and with a measurement receiver (15) provided at the end of the measurement path (13) which receives the wave pulses and converts them into an electrical received pulse, wherein the pulse generator (11) which can be triggered by one pulse flank and a light modulator (31) acted on by the pulse generator (11) are arranged in a feedback loop (12) extending between the output (17) of the light modulator (31) and the trigger input (18), wherein the feedback loop has a received pulse time determination circuit (34, 35, 36, 37, 39) before the pulse generator (11) into which either the measurement path (13) or a reference path (14) having a reference receiver (16) at the end can be alternately incorporated for a measurement time interval (T1) and for a reference time interval (T2) respectively which are both large relative to the pulse repetition time, and wherein a computing counting stage (19) counts the circuits of the wave pulse in the feedback loop (12) and also computes the transit time from the length of the measurement time interval and from the length of the reference time interval and the number of pulses transmitted during them, characterised in that the pulse generator (11) transmits, each time it is triggered, a short sequence of pulses (9, 10) of the same length and the same amplitude, wherein the spacing between two sequential transmitted pulses is the same apart from the spacing of the last pulse (10) from the penultimate pulse and wherein the last pulse (10) has an additional phase shift of 180° relative to the penultimate one; in that the pulse reception time determination circuit includes a resonator (35) tuned to the frequency of the pulse group (8) of sequential, equally spaced pulses (9) present before the pulse (10) additionally phase-shifted by 180° and thereafter a detector circuit (36, 37, 38, 39) at the resonator (35) which, as a result of the sudden collapse of the resonator oscillation (7) excited by the pulse group (8), defines the time of the directly preceding zero passage as the time of reception of the short sequence of pulses (9, 10) from which the triggering of the next short sequence of pulses (9, 10) takes place, after a predetermined refresh time.

2. Apparatus in accordance with claim 1, characterised in that the detector circuit has a zero passage detector (36) and an envelope curve detector (37) connected in parallel to the latter, to the inputs of which the output of the resonator (35) is applied and the outputs of which are applied to the setting input (S) and the resetting input (R) respectively of a pretrigger (38) in such a way, that after the collapse of the resonator oscillation (7) excited by the pulse group (8) only the directly preceding zero passage of the resonator oscillation sets the pretrigger (38), the next maximum of the resonator oscillation can however no longer reset the pretrigger (38).

3. Apparatus in accordance with claim 2, characterised in that the envelope curve detector (37) only then transmits a resetting signal when the resonator oscillation exceeds a predetermined fraction of the maximum of the envelope curve (6) of the resonator oscillation (7) preceding a cycle and in that the threshold formation required for this takes place by means of counting of the envelope curve pulses.

4. Apparatus in accordance with one of the preceding claims, characterised in that a refresh time circuit (39) is provided adjoining the pretrigger (38) which delays the transmission of a counting trigger pulse to the pulse generator (11) and to the computing counting stage (19) by a fixed regeneration time.

5. Apparatus in accordance with one of the preceding claims, characterised in that the fixed refresh time or regeneration time amounts to 2 to 200 ns, preferably 20 to 100 ns and in particular to two oscillation periods of the resonant frequency.

6. Apparatus in accordance with one of the preceding claims, characterised in that from 3 to 10, preferably from 5 to 9 and in particular 8 equally spaced pulses (9) are provided before the last pulse (10) which is additionally phase-shifted by 180°.

7. Apparatus in accordance with one of the preceding claims, characterised in that an amplitude limiter (34) is arranged before the resonator (35).

8. Apparatus in accordance with one of the preceding claims, characterised in that the limiter (34), the zero passage detector (36), the envelope curve detector (37), the pretrigger (38), the refresh time circuit (39) and the pulse generator (11) are formed on a single semiconductor component chip.

9. Apparatus in accordance with one of the preceding claims, characterised in that the computing counting stage (19) includes a forward-rearward counter at which the measurement time is first clocked in in one counting direction and the reference time is then clocked out in the opposite counting direction.

10. Apparatus in accordance with one of the preceding claims, characterised in that the refresh time or regeneration time (T) is selected to be sufficiently long that before the appearance of the trigger pulse flank (2) the associated transmission process in the pulse generator (11) has completely died away.

11. Apparatus in accordance with claim 3, characterised in that the predetermined fraction exceeds $1/\sqrt{2}$ times the maximum of the envelope curve (6) of the resonator oscillation preceding a cycle.

12. Apparatus in accordance with claim 3, characterised in that the threshold formation takes place through a digital three-point regulation by means of counting of the envelope curve pulses.

**Revendications**

1. Appareil pour mesurer le temps de propagation d'ondes lumineuses, sur un trajet de mesure (13) d'une longueur prédéterminée, avec un émetteur (32) piloté par un générateur d'impulsions électrique (11), ledit émetteur envoyant les ondes électriques sous forme d'impulsions d'ondes sur le trajet de mesure (13), et comprenant un récepteur de mesure (15) prévu à l'extrémité du trajet de mesure (13), ledit récepteur recevant les impulsions d'ondes et les transformant en une impulsion électrique de réception ; le générateur d'impulsions (11), susceptible d'être déclenché par un flanc d'impulsion, et un modulateur de lumière (31) attaqué par ce générateur d'impulsions, étant agencés dans une boucle de rétroaction (12) qui s'étend entre la sortie (17) du modulateur de lumière (31) et l'entrée de gâchette (18), ladite boucle de rétroaction comportant devant le générateur d'impulsions (11) un circuit de détermination (34, 35, 36, 37, 38, 39) pour déterminer l'instant de réception des impulsions, et dans cette boucle de rétroaction peuvent être introduits à contre temps soit le trajet de mesure (13) soit un trajet de référence (14) qui comporte à l'extrémité un récepteur de référence (16), pendant un temps de mesure (T1) ou pendant un temps référence (T2), qui sont tous deux importants par rapport à la durée de répétition des impulsions, et dans lequel un étage de comptage (19) compte les passages des impulsions d'ondes dans la boucle de rétroaction (12), et calcule le temps de propagation à partir de la longueur du temps de mesure ou du temps de référence, et à partir du nombre des impulsions délivrées pendant ce temps,
caractérisé en ce que
le générateur d'impulsions (11) délivre à chaque déclenchement une courte succession d'impulsions (9, 10) qui présentent la même longueur et la même amplitude, et la distance entre deux impulsions émises l'une après l'autre est égale à la distance entre la dernière impulsion (10) et l'avant-dernière impulsion, et la dernière impulsion (10) présente vis-à-vis de l'avant-dernière impulsion un décalage de phase additionnel de 180°, en ce que le circuit de détermination de l'instant de réception des impulsions comprend un résonateur (35) qui est accordé à la fréquence du groupe d'impulsions (8) qui sont présentes devant l'impulsion (10) avec un décalage de phase additionnel de 180°, et qui ont la même distance les unes des autres, parmi les impulsions successives (9), et à la suite du résonateur (35) un circuit de détection (36, 37, 38, 39) qui, en raison de l'effondrement soudain de l'oscillation de résonateur excitée par le groupe d'impulsions (8), définit l'instant du passage à zéro immédiatement précédent comme étant l'instant de réception de la courte succession d'impulsions (9, 10), à partir duquel a lieu le déclenchement de la courte succession suivante d'impulsions (9, 10) après un temps de rafraîchissement prédéterminé.

2.  Appareil selon la revendication 1, caractérisé en ce que le circuit de détection comporte un détecteur de passage à zéro (36) et un détecteur de courbe enveloppe (37) branché en parallèle à celui-ci, la sortie du résonateur (35) étant appliquée aux entrées de ces deux détecteurs, et leurs sorties étant appliquées à l'entrée de mise en route (S) ou de remise à zéro (R) d'une pré-gâchette (38), de telle manière qu'après l'effondrement de l'oscillation de résonateur (7) excitée par le groupe d'impulsions (8) seul le passage à zéro immédiatement précédent de l'oscillation de résonateur met en route la pré-gâchette (38), mais que le maximum suivant de l'oscillation du résonateur ne peut plus remettre à zéro la pré-gâchette (38).

3.  Appareil selon la revendication 2, caractérisé en ce que le détecteur de courbe enveloppe (37) ne délivre un signal de remise à zéro que lorsque l'oscillation de résonateur dépasse une fraction prédéterminée du maximum de la courbe enveloppe (6) de l'oscillation de résonateur (7) qui précède un cycle, et en ce que la formation de seuil nécessaire à cet effet a lieu par comptage des impulsions de courbe enveloppe.

4.  Appareil selon l'une des revendications précédentes, caractérisé en ce qu'il est prévu à la suite de la pré-gâchette (38) un temporisateur de rafraîchissement (39), qui retarde la délivrance d'une impulsion de déclenchement de comptage au générateur d'impulsions (11) et retarde l'étage de comptage (19) d'un temps fixe de régénération.

5.  Appareil selon l'une quelconque des revendications précédentes, caractérisé en ce que le temps de fixe de rafraîchissement ou de régénération s'élève de 2 à 200 ns, de préférence de 20 à 100 ns, et est en particulier égal à deux périodes d'oscillations de la fréquence de résonance.

6.  Appareil selon l'une des revendications précédentes, caractérisé en ce que, avant la dernière impulsion (10) qui présente un décalage de phase additionnel de 180°, sont prévues 3 à 10 impulsions (9), de préférence 5 à 9, et en particulier 8 impulsions, qui présentent la même distance.

7.  Appareil selon l'une des revendications précédentes, caractérisé en ce que devant le résonateur (35) est agencé un limiteur d'amplitude (34).

8.  Appareil selon l'une des revendications précédentes, caractérisé en ce que le limiteur (34), le détecteur de passage à zéro (36), le détecteur de courbe enveloppe (37), la pré-gâchette (38), le temporisateur de rafraîchissement (39), et le générateur d'impulsions (11) sont réalisés sur un composant unique à semi-conducteur.

9.  Appareil selon l'une des revendications précédentes, caractérisé en ce que l'étage de comptage (19) comprend un compteur montant/descendant, dans lequel le temps de mesure est d'abord cadencé dans une direction de comptage, et ensuite le temps de référence est cadencé dans la direction de comptage opposée.

10. Appareil selon l'une des revendications précédentes, caractérisé en ce que le temps de rafraîchissement ou de régénération (T) est choisi d'une longueur telle qu'avant apparition des flancs (2) de l'impulsion de déclenchement, l'opération d'émission associée est entièrement disparue dans le générateur d'impulsions (11).

11. Appareil selon la revendication 3, caractérisé en ce que la fraction prédéterminée dépasse $1/\sqrt{2}$ fois le maximum de la courbe enveloppe (6) de l'oscillation de résonateur (7) qui précède d'un cycle.

12. Appareil selon la revendication 3, caractérisé en ce que la formation de seuil a lieu par une régulation numérique à 3 points par comptage des impulsions de la courbe enveloppe.

# Fig. 1

Fig. 2

Fig. 3

Fig.4

Fig. 5

Fig. 6

Fig. 7

Fig.8